# EUROPEAN PATENT SPECIFICATION

(11) **EP 4 648 575 B1**
(45) Date of publication and mention of the grant of the patent: **28.10.2026**
(21) Application number: 25171636.1
(22) Date of filing: 22.04.2025
(51) Int. Cl.: H10D 30/67

(54) **SEMICONDUCTOR DEVICE**
HALBLEITERANORDNUNG
DISPOSITIF SEMI-CONDUCTEUR

(30) Priority: 07.05.2024 KR 20240059885
(43) Date of publication of application: 12.11.2025
(73) Proprietor: Samsung Electronics Co., Ltd., Suwon-si, Gyeonggi-do 16677 (KR)
(72) Inventor: HAN, Narae, 16678 Suwon-si (KR); JANG, Younjin, 16678 Suwon-si (KR); KIM, Sangwook, 16678 Suwon-si (KR); HAN, Joohun, 16678 Suwon-si (KR)
(74) Representative: Elkington and Fife LLP

(56) References cited:
- CN-A- 110 690 118
- US-A1- 2019 341 463
- US-A1- 2019 378 932

## Description

### FIELD OF THE INVENTION

The inventive concepts relate to semiconductor devices, and more particularly, to semiconductor devices including an oxide semiconductor.

### BACKGROUND OF THE INVENTION

As semiconductor devices performing an electrical switching function, transistors have been used in various integrated circuit (IC) devices including memories, driving ICs, logic devices, and the like. In order to increase the integration degree of IC devices, the space occupied by transistors arranged therein has rapidly decreased, and thus, research has been conducted to reduce the size of transistors while maintaining the performance thereof.

Oxide semiconductor devices have been researched for many years as transparent semiconductor devices with the characteristic of having a wide bandgap of 3.0 eV or more. Oxide semiconductor devices used as large-area display driving devices have excellent characteristics such as low off-currents and high on/off ratios. Research has been conducted to use oxide semiconductor devices with such advantages as memories or logic devices.

US2019378932A1 discloses an oxide semiconductor thin film transistor having a multi-layer gate insulating layer. The gate dielectric stack may comprise alternating layers of a first high-k dielectric layer and a second high-k dielectric layer, and a third high-k dielectric layer. The alternating layers may comprise a superlattice. The third high-k dielectric layer may be formed as an uppermost layer of the gate dielectric stack. The third high-k dielectric layer may be a material that is particularly resistant to crystallizing.

### SUMMARY OF THE INVENTION

Some example embodiments of the inventive concepts include a semiconductor device including a gate insulating layer including a plurality of insulating layers with different energy bandgaps stacked therein.

Additional aspects will be set forth in part in the description which follows and, in part, will be apparent from the description, or may be learned by practice of the presented embodiments of the inventive concepts.

According to some example embodiments of the inventive concepts, a semiconductor device includes an oxide semiconductor layer, a gate electrode arranged apart from the oxide semiconductor layer, and a gate insulating layer arranged between the oxide semiconductor layer and the gate electrode in a thickness direction of the gate insulating layer, wherein the gate insulating layer includes a plurality of first insulating layers arranged apart from each other in a thickness direction of the gate insulating layer, a second insulating layer arranged between a first set of adjacent first insulating layers among the plurality of first insulating layers and having a smaller energy bandgap than the first insulating layer, and a third insulating layer arranged between a second set of adjacent first insulating layers among the plurality of first insulating layers and having a greater energy bandgap than the first insulating layer, and wherein the third insulating layer is closer to the oxide semiconductor layer than the second insulating layer.

A content of the second insulating layer in the gate insulating layer may be 10 at% or less.

A content of the third insulating layer in the gate insulating layer may be 10 at% or less.

The plurality of first insulating layers may include two outermost first insulating layers among the plurality of first insulating layers in the thickness direction of the gate insulating layer and at least one inner first insulating layer between the two outermost first insulating layers, and a thickness in the vertical direction of each of the two outermost first insulating layers among the plurality of first insulating layers is greater than or equal to a thickness in the thickness direction of the gate insulating layer of the at least one inner first insulating layer among the plurality of first insulating layers.

One of the two outermost first insulating layers contacts the oxide semiconductor layer.

One of the two outermost first insulating layers contacts the gate electrode.

A first insulating layer among the plurality of first insulating layers may be arranged between the second insulating layer and the third insulating layer.

A thickness of each first insulating layer of the plurality of first insulating layers in the thickness direction of the gate insulating layer may be greater than a thickness of each layer of the second insulating layer and the third insulating layer in the thickness direction of the gate insulating layer.

At least one of the second insulating layer and the third insulating layer may include a single atomic layer.

A thickness of at least one of the second insulating layer or the third insulating layer in the thickness direction of the gate insulating layer may be 3Å or less.

A thickness of each first insulating layer of the plurality of first insulating layers in the thickness direction of the gate insulating layer may be 5Å or more.

A thickness of the gate insulating layer in the thickness direction of the gate insulating layer may be about 3 nm to about 10 nm.

A sum of layers of the plurality of first insulating layers, the second insulating layer, and the third insulating layer may be 4n+1, where n is a natural number.

The second insulating layer may include a plurality of second insulating layers and the third insulating layer may include a plurality of third insulating layers, and the plurality of second insulating layers and the plurality of third insulating layers may be alternately arranged one by one in the thickness direction of the gate insulating layer.

A first insulating layer of the plurality of first insulating layers may be arranged between the second insulating layer and the third insulating layer.

An energy bandgap difference between the second insulating layer and the third insulating layer may be 5 eV or more.

The third insulating layer may include an oxide including at least one of silicon (Si) or magnesium (Mg).

The second insulating layer may include at least one of titanium (Ti) or hafnium (Hf).

An energy bandgap difference between a first insulating layer among the plurality of first insulating layers and at least one of the second insulating layer or the third insulating layer may be 2 eV or more.

The plurality of first insulating layers may each independently include an oxide, the oxide comprising at least one of aluminum (Al), calcium (Ca), yttrium (Y), zirconium (Zr), or hafnium (Hf).

The semiconductor device may further include a bit line electrically connected to one end of the oxide semiconductor layer, and a capacitor electrically connected to another end of the oxide semiconductor layer, wherein the gate electrode may be an element of a word line.

### BRIEF DESCRIPTION OF THE DRAWINGS

The above and other aspects, features, and advantages of some example embodiments of the inventive concepts will be more apparent from the following description taken in conjunction with the accompanying drawings, in which:
FIG. 1 is a diagram illustrating a semiconductor device according to some example embodiments;
FIG. 2 is a diagram illustrating a semiconductor device including a plurality of second insulating layers and a plurality of third insulating layers according to some example embodiments;
FIG. 3 is a diagram illustrating the result of measuring the performance of semiconductor devices including various types of insulating layers according to some example embodiments;
FIG. 4 is a diagram illustrating the result of measuring the positive bias temperature instability (PBTI) of a semiconductor device according to some example embodiments;
FIG. 5 is a diagram illustrating the result of measuring the negative bias temperature instability (NBTI) of a semiconductor device according to some example embodiments;
FIG. 6 is a diagram illustrating a semiconductor device operating as a transistor according to some example embodiments;
FIG. 7 is a diagram illustrating a semiconductor device further including a plurality of gate electrodes according to some example embodiments;
FIG. 8 is a diagram illustrating a semiconductor device according to some example embodiments;
FIG. 9 is a diagram illustrating a semiconductor device according to some example embodiments;
FIG. 10 is a diagram illustrating a semiconductor device according to some example embodiments;
FIG. 11 is a diagram illustrating a semiconductor device according to some example embodiments;
FIG. 12 is a perspective view illustrating a schematic structure of a vertical stack memory device according to some example embodiments;
FIG. 13 is a perspective view illustrating a schematic structure of a vertical stack memory device according to some example embodiments;
FIG. 14 is a block diagram illustrating an electronic system according to some example embodiments; and
FIG. 15 is a block diagram of an electronic system according to some example embodiments.

### DETAILED DESCRIPTION

Reference will now be made in detail to example embodiments, some of which are illustrated in the accompanying drawings, wherein like reference numerals refer to like elements throughout. In this regard, the present embodiments may have different forms and should not be construed as being limited to the descriptions set forth herein. Accordingly, the embodiments are merely described below, by referring to the figures, to explain aspects. As used herein, the term "and/or" includes any and all combinations of one or more of the associated listed items. Expressions such as "at least one of," when preceding a list of elements, modify the entire list of elements and do not modify the individual elements of the list.

Hereinafter, semiconductor devices including a multi-layer structure according to various embodiments will be described in detail with reference to the accompanying drawings. Like reference numerals in the drawings will denote like elements, and sizes of elements in the drawings may be exaggerated for clarity and convenience of description.

As used herein, the singular forms "a", "an", and "the" are intended to include the plural forms as well, unless the context clearly indicates otherwise. Also, when something is referred to as "including" a component, another component may be further included unless specified otherwise. Also, in the drawings, the size or thickness of each element may be exaggerated for clarity of description. Also, when a material layer is referred to as being "on" a substrate or another layer, it may be directly on the substrate or the other layer or one or more intervening layers may be present therebetween. Also, in the following embodiments, because materials forming each layer are merely examples, other materials may also be used.

Also, as used herein, the terms "units" and "modules" may refer to units that perform at least one function or operation, and the units may be implemented as hardware or software or a combination of hardware and software.

Particular implementations described in the present embodiments are merely examples, and do not limit the scope of the inventive concepts in any way. For the sake of conciseness, descriptions of related art electronic configurations, control systems, software, and other functional aspects of the systems may be omitted.

Also, connections or connection members of lines between the elements illustrated in the drawings may illustratively represent functional connections and/or physical or logical connections and may be represented as various replaceable or additional functional connections, physical connections, or logical connections in an actual apparatus.

The use of the terms "a", "an", and "the" and other similar indicative terms may be construed to cover both the singular and the plural.

Expressions such as "at least one of," when preceding a list of elements, modify the entire list of elements and do not modify the individual elements of the list. For example, an expression such as "at least one of A, B, and C" or "at least one selected from the group consisting of A, B, and C" may be interpreted as only A, only B, only C, or any combination of two or more of A, B, and C, such as A, B, and C, A and B, B and C, and A and C.

It will be understood that elements and/or properties thereof (e.g., structures, surfaces, directions, or the like), which may be referred to as being "perpendicular," "parallel," "coplanar," or the like with regard to other elements and/or properties thereof (e.g., structures, surfaces, directions, or the like) may be "perpendicular," "parallel," "coplanar," or the like or may be "substantially perpendicular," "substantially parallel," "substantially coplanar," respectively, with regard to the other elements and/or properties thereof.

Elements and/or properties thereof (e.g., structures, surfaces, directions, or the like) that are "substantially perpendicular", "substantially parallel", or "substantially coplanar" with regard to other elements and/or properties thereof will be understood to be "perpendicular", "parallel", or "coplanar", respectively, with regard to the other elements and/or properties thereof within manufacturing tolerances and/or material tolerances and/or have a deviation in magnitude and/or angle from "perpendicular", "parallel", or "coplanar", respectively, with regard to the other elements and/or properties thereof that is equal to or less than 10% (e.g., a. tolerance of ±10%).

It will be understood that elements and/or properties thereof may be recited herein as being "identical", "the same", or "equal" as other elements and/or properties thereof, and it will be further understood that elements and/or properties thereof recited herein as being "identical" to, "the same" as, or "equal" to other elements and/or properties thereof may be "identical" to, "the same" as, or "equal" to or "substantially identical" to, "substantially the same" as or "substantially equal" to the other elements and/or properties thereof. Elements and/or properties thereof that are "substantially identical" to, "substantially the same" as or "substantially equal" to other elements and/or properties thereof will be understood to include elements and/or properties thereof that are identical to, the same as, or equal to the other elements and/or properties thereof within manufacturing tolerances and/or material tolerances. Elements and/or properties thereof that are identical or substantially identical to, equal to or substantially equal to, and/or the same or substantially the same as other elements and/or properties thereof may be structurally the same or substantially the same, functionally the same or substantially the same, and/or compositionally the same or substantially the same. While the term "same," "equal" or "identical" may be used in description of some example embodiments, it should be understood that some imprecisions may exist. Thus, when one element or property is referred to as being identical to, equal to, or the same as another element or property, it should be understood that the element or property is the same as another element or property within a desired manufacturing or operational tolerance range (e.g., ±10%).

It will be understood that elements and/or properties thereof described herein as being "substantially" the same, equal, and/or identical encompasses elements and/or properties thereof that have a relative difference in magnitude that is equal to or less than 10%. Further, regardless of whether elements and/or properties thereof are modified as "substantially," it will be understood that these elements and/or properties thereof should be construed as including a manufacturing or operational tolerance (e.g., ±10%) around the stated elements and/or properties thereof.

When the terms "about" or "substantially" are used in this specification in connection with a numerical value, it is intended that the associated numerical value includes a manufacturing or operational tolerance (e.g., ±10%) around the stated numerical value. Moreover, when the words "about" and "substantially" are used in connection with geometric shapes, it is intended that precision of the geometric shape is not required but that latitude for the shape is within the scope of the disclosure. Further, regardless of whether numerical values or shapes are modified as "about" or "substantially," it will be understood that these values and shapes should be construed as including a manufacturing or operational tolerance (e.g., ±10%) around the stated numerical values or shapes. When ranges are specified, the range includes all values therebetween such as increments of 0.1%.

As described herein, when an operation is described to be performed, or an effect such as a structure is described to be established "by" or "through" performing additional operations, it will be understood that the operation may be performed and/or the effect/structure may be established "based on" the additional operations, which may include performing said additional operations alone or in combination with other further additional operations.

As described herein, an element that is described to be "spaced apart" or "arranged apart" from another element, in general and/or in a particular direction (e.g., vertically spaced apart, laterally spaced apart, etc.) and/or described to be "separated from" the other element, may be understood to be isolated from direct contact with the other element, in general and/or in the particular direction (e.g., isolated from direct contact with the other element in a vertical direction, isolated from direct contact with the other element in a lateral or horizontal direction, etc.). Similarly, elements that are described to be "spaced apart" from each other, in general and/or in a particular direction (e.g., vertically spaced apart, laterally spaced apart, etc.) and/or are described to be "separated" from each other, may be understood to be isolated from direct contact with each other, in general and/or in the particular direction (e.g., isolated from direct contact with each other in a vertical direction, isolated from direct contact with each other in a lateral or horizontal direction, etc.). Similarly, a structure described herein to be between two other structures to separate the two other structures from each other may be understood to be configured to isolate the two other structures from direct contact with each other.

Although terms such as "first" and "second" may be used herein to describe various elements or components, these elements or components should not be limited by these terms. These terms are only used to distinguish one element or component from another element or component.

All examples or illustrative terms used herein are merely intended to describe the technical concept of the inventive concepts in detail, and the scope of the inventive concepts is not limited by these examples or illustrative terms unless otherwise defined in the appended claims.

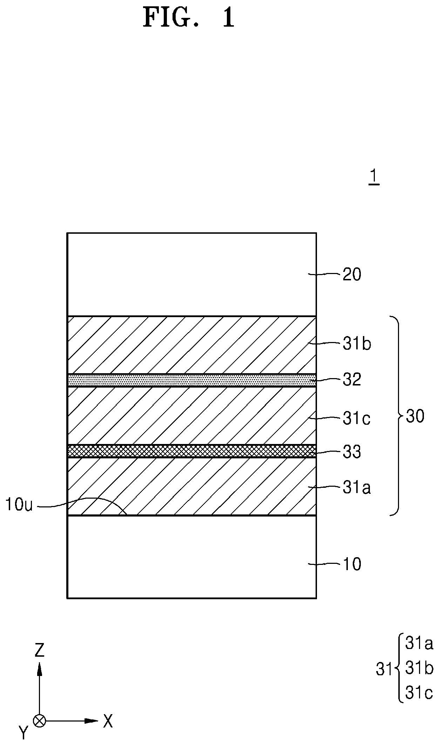

FIG. 1 is a diagram illustrating a semiconductor device 1 according to some example embodiments. The semiconductor device 1 of FIG. 1 may be a transistor or a memory cell. Referring to FIG. 1, the semiconductor device 1 may include an oxide semiconductor layer 10, a gate electrode 20 arranged apart from the oxide semiconductor layer 10, and a gate insulating layer 30 arranged between the oxide semiconductor layer 10 and the gate electrode 20. It will be understood that elements recited herein as being "arranged apart" from other elements may be referred to interchangeably as being "spaced apart" from the other elements, "isolated from direct contact with" the other elements, or the like.

The oxide semiconductor layer 10 according to some example embodiments may include an oxide of a material selected from a group 12, 13, and 14 metal element such as zinc (Zn), indium (In), gallium (Ga), tin (Sn), cadmium (Cd), germanium (Ge), or hafnium (Hf), or any combination thereof. For example, the oxide semiconductor layer 10 may include a Zn oxide-based material such as a Zn oxide, an In-Zn oxide, or an In-Ga-Zn oxide. As an example, the oxide semiconductor layer 10 may be provided in a single-layer or multi-layer structure. The thickness of the oxide semiconductor layer 10 may be about 10 nm or less, about 8 nm or less, or about 7 nm or less. For example, the thickness of the oxide semiconductor layer 10 may be about 0.01 nm to about 10 nm, about 0.01 nm to about 8 nm, or about 0.01 nm to about 7 nm. Oxide semiconductors may have excellent characteristics such as low off-currents, low subthreshold swings, and high on/off ratios and thus may be used in memory devices or logic devices.

The semiconductor device 1 according to some example embodiments may include a gate electrode 20 arranged apart from the oxide semiconductor layer 10. The gate electrode 20 may include at least one of tungsten (W), cobalt (Co), nickel (Ni), iron (Fe), titanium (Ti), molybdenum (Mo), chromium (Cr), zirconium (Zr), hafnium (Hf), niobium (Nb), tantalum (Ta), silver (Ag), gold (Au), aluminum (Al), copper (Cu), tin (Sb), vanadium (V), ruthenium (Ru), platinum (Pt), zinc (Zn), or magnesium (Mg). When the semiconductor device 1 is a component of a memory cell, the gate electrode 20 may be a partial area of a word line.

The semiconductor device 1 according to some example embodiments may include a gate insulating layer 30 arranged between the oxide semiconductor layer 10 and the gate electrode 20. The gate insulating layer 30 may be in a form in which a plurality of layers with different energy bandgaps are stacked. For example, the gate insulating layer 30 may include a plurality of layers arranged such that the energy bandgap increases and decreases repeatedly in the direction from the oxide semiconductor layer 10 to the gate electrode 20 (or the thickness direction of the insulating layer, or the Z-axis direction). The Z-axis direction may be referred to herein interchangeably as a vertical direction, a thickness direction, or the like. The thickness of the gate insulating layer 30 (e.g., the thickness in the Z-axis direction) may be about 3 nm to about 10 nm. As described herein, the thickness direction, Z-axis direction, or the like may be a direction that extends perpendicular to a surface of the semiconductor device 1, for example perpendicular to an upper surface 10u of the oxide semiconductor layer 10 that faces towards the gate electrode 20 and the gate insulating layer 30. Accordingly, the X-axis and Y-axis directions, which may be referred to as horizontal directions, first and second horizontal directions, or the like, may extend perpendicular to the Z-axis direction and may extend perpendicular to each other and/or may each extend parallel to the surface of the semiconductor device 1, for example parallel to an upper surface 10u of the oxide semiconductor layer 10 that faces towards the gate electrode 20 and the gate insulating layer 30.

The gate insulating layer 30 according to some example embodiments may include a plurality of first insulating layers 31 arranged apart (e.g., spaced apart) from each other in the thickness direction of the gate insulating layer 30 (the Z-axis direction). The plurality of first insulating layers 31 may be three or more in number (quantity). For example, the plurality of first insulating layers 31 may include two first insulating layers 31a and 31b arranged at the outer side among the plurality of first insulating layers 31 (which may be referred to herein interchangeably as two outermost first insulating layers 31a and 31b ) and one or more first insulating layers 31c arranged at the inner side among the plurality of first insulating layers 31 (which may be referred to herein interchangeably as one or more inner first insulating layers 31c that are each between two or more first insulating layers among the plurality of first insulating layers 31). Restated, the plurality of first insulating layers 31 may include two outermost first insulating layers 31a and 31b among the plurality of first insulating layers 31 in the Z-axis direction and one or more inner first insulating layers 31c that are each between two or more first insulating layers among the plurality of first insulating layers 31 (e.g., between at least the two outermost first insulating layers 31a and 31b) in the Z-axis direction. Among the two first insulating layers 31a and 31b arranged at the outer side (e.g., the two outermost first insulating layers), one first insulating layer 31a may contact (e.g., directly contact) the oxide semiconductor layer 10 and the other first insulating layer 31b may contact (e.g., directly contact) the gate electrode 20.

The thickness of each first insulating layer of the plurality of first insulating layers 31 may be about 5 Å or more, for example between about 5 Å and about 500 Å, between about 5 Å and about 100 Å, between about 5 Å and about 50 Å, or between about 5 Å and about 10 Å. The thickness of each of the two first insulating layers 31a and 31b arranged at the outer side (e.g., a thickness in the Z-axis direction of each of the two outermost first insulating layers 31a and 31b among the plurality of first insulating layers 31) may be greater than or equal to the thickness of the first insulating layer 31c arranged at the inner side (e.g., a thickness in the Z-axis direction of the at least one inner first insulating layer 31c among the plurality of first insulating layers 31). For example, the thickness of each of the two first insulating layers 31a and 31b arranged at the outer side may be about 1.5 times or more the thickness of the first insulating layer 31c arranged at the inner side. For example, the thickness of each of the two first insulating layers 31a and 31b arranged at the outer side may be about 1.5 times to about 100 times the thickness of the first insulating layer 31c arranged at the inner side, about 1.5 times to about 50 times the thickness of the first insulating layer 31c arranged at the inner side, about 1.5 times to about 10 times the thickness of the first insulating layer 31c arranged at the inner side, or about 1.5 times to about 5 times the thickness of the first insulating layer 31c arranged at the inner side.

The content of the plurality of first insulating layers 31 in the gate insulating layer 30 may be predominant. For example, the content of the plurality of first insulating layers 31 in the gate insulating layer 30 may be about 80 at% or more or about 85 at% or more as a proportion of the total quantity of atoms of the gate insulating layer 30. For example, the content of the plurality of first insulating layers 31 in the gate insulating layer 30, as a proportion of the total quantity of atoms of the gate insulating layer 30, may be about 85 at% to about 99 at%, about 85 at% to about 95 at%, about 85 at% to about 90 at%, 80 at% to about 99 at%, about 80 at% to about 95 at%, or about 80 at% to about 90 at%. Thus, the threshold voltage of the semiconductor device 1 may be mainly determined by the plurality of first insulating layers 31. The plurality of first insulating layers 31 may include a material with an energy bandgap of about 4 eV to about 7 eV. In some example embodiments, the plurality of first insulating layers 31 may include a material with a dielectric constant of about 10 to about 40. For example, the plurality of first insulating layers 31 may include an oxide including at least one of aluminum (Al), calcium (Ca), yttrium (Y), zirconium (Zr), lanthanum (La), or hafnium (Hf), for example at least one of an aluminum oxide, a calcium oxide, a yttrium oxide, a zirconium oxide, a lanthanum oxide, or a hafnium oxide.

In a semiconductor device including an insulating layer including one type of material layer, excess oxygen may be easily generated in the insulating layer in a subsequent process or a heat treatment process. The generated excess oxygen may move to an oxide semiconductor layer to suppress generation of oxygen vacancies in the oxide semiconductor layer. The gate insulating layer 30 according to some example embodiments may restrict the movement of excess oxygen generated in the gate insulating layer 30, thereby improving generation of oxygen vacancies in the oxide semiconductor layer 10 and thus improving the functionality and reliability of the semiconductor device 1, by including a plurality of layers with different energy bandgaps (e.g., the first, second, and third insulating layers 31, 32, and 33) in the gate insulating layer 30.

The gate insulating layer 30 according to some example embodiments may further include a second insulating layer 32 arranged between (e.g., directly between or indirectly between) adjacent first insulating layers 31b and 31c (e.g., a first set of adjacent first insulating layers) among the plurality of first insulating layers 31 and having a smaller energy bandgap than the plurality of first insulating layers 31. Both sides of the second insulating layer 32 opposite to each other (e.g., opposite sides of the second insulating layer 32 in the Z-axis direction) may respectively contact the first insulating layers 31b and 31c.

The content of the second insulating layer 32 in the gate insulating layer 30 may be low. For example, the content of the second insulating layers 32 in the gate insulating layer 30 may be about 10 at% or less. For example, the content of the second insulating layer 32 in the gate insulating layer 30, as a proportion of the total quantity of atoms of the gate insulating layer 30, may be about 0.01 at% to about 10 at%, about 0.1 at% to about 10 at%, about 1 at% to about 10 at%, 1 at% to about 8 at%, about 1 at% to about 5 at%, or about 1 at% to about 2 at%. The thickness of the second insulating layer 32 (e.g., the thickness in the Z-axis direction) may be less than the respective thickness of each first insulating layer of the plurality of first insulating layers 31. For example, the thickness of the second insulating layer 32 (e.g., the thickness thereof in the Z-axis direction) may be about 3 Å or less, for example, about 2 Å or less. For example, the thickness of the second insulating layer 32 (e.g., the thickness thereof in the Z-axis direction) may be about 0.01 Å to about 2 Å, about 0.1 Å to about 2 Å, about 1 Å to about 2 Å, about 1 Å to about 1.5 Å, or about 1 Å to about 1.1 Å. In some example embodiments, the second insulating layer 32 may be a single atomic layer. Thus, the threshold voltage of the semiconductor device 1 may be less affected by the second insulating layer 32.

The difference between the energy bandgap of the first insulating layer 31 and the energy bandgap of the second insulating layer 32 may be about 2 eV or more, for example about 2 eV to about 200 eV, about 2 eV to about 100 eV, about 2 eV to about 50 eV, about 2 eV to about 20 eV, about 2 eV to about 10 eV, or about 2 eV to about 5 eV. For example, the second insulating layer 32 may include a material having an energy bandgap of about 4 eV or less, for example about 0.01 eV to about 4 eV, about 0.1 eV to about 4 eV, about 1 eV to about 4 eV, about 1 eV to about 3 eV, about 1 eV to about 2 eV, or about 1 eV to about 1.5 eV. In some example embodiments, the second insulating layer 32 may include a material with a dielectric constant of about 20 or more, for example about 20 to about 200, about 20 to about 100, about 20 to about 50, about 20 to about 40, or about 20 to about 30. For example, the second insulating layer 32 may include an oxide including at least one of hafnium (Hf), tantalum (Ta), barium (Ba), or titanium (Ti) (e.g., at least one of a hafnium oxide, a tantalum oxide, a barium oxide, or a titanium oxide).

The gate insulating layer 30 may be configured to improve the functionality and/or reliability of the semiconductor device 1 may on including a plurality of layers with different energy bandgaps. For example, the second insulating layer 32 with a small energy bandgap may easily generate a dielectric polarization by an applied electric field, thus increasing the on-current of the oxide semiconductor layer 10, and thereby improving the functionality and/or reliability of the semiconductor device 1. In addition, the second insulating layer 32 with a small energy bandgap may have a small oxygen scavenge effect, thus attracting oxygen from an adjacent layer to restrict the movement of oxygen to the oxide semiconductor layer 10, and thereby improving the functionality and/or reliability of the semiconductor device 1.

However, when the second insulating layer 32 with a small energy bandgap is arranged adjacent to (e.g., directly adjacent to, contacting, etc.) the oxide semiconductor layer 10, the reliability of the semiconductor device 1 may be degraded due to charge trapping and/or de-trapping. Thus, the second insulating layer 32 according to some example embodiments may be arranged between (e.g., directly or indirectly between) the adjacent first insulating layers 31b and 31c so as not to contact the oxide semiconductor layer 10, thereby improving the functionality and/or reliability of the semiconductor device 1.

Also, the gate insulating layer 30 according to some example embodiments may further include a third insulating layer 33 having a greater energy bandgap than the first insulating layer 31 in order to prevent charge trapping and/or de-trapping, or reduce or minimize such trapping and/or de-trapping, and thereby improving the functionality and/or reliability of the semiconductor device 1. The third insulating layer 33 may be arranged more adjacent to the oxide semiconductor layer 10 (e.g., closer to the oxide semiconductor layer 10, for example in the Z-axis direction) than the second insulating layer 32, thereby preventing the charge trapping and/or de-trapping by the second insulating layer 32, or reducing or minimizing such trapping and/or de-trapping, and thereby improving the functionality and/or reliability of the semiconductor device 1. The third insulating layer 33 may be arranged between (e.g., directly between) the first insulating layers 31a and 31c (e.g., a second set of adjacent first insulating layers among the plurality of first insulating layers 31). Both surfaces of the third insulating layer 33 opposite to each other (e.g., opposite surface of the third insulating layer 33 in the Z-axis direction) may respectively contact the first insulating layers 31a and 31c. That is, the first insulating layer 31c may be arranged between the second insulating layer 32 and the third insulating layer 33.

The content of the third insulating layer 33 in the gate insulating layer 30 may be low. For example, the content of the third insulating layer 33 in the gate insulating layer 30 may be about 10 at% or less. For example, the content of the third insulating layer 33 in the gate insulating layer 30, as a proportion of the total quantity of atoms of the gate insulating layer 30, may be about 0.01 at% to about 10 at%, about 0.1 at% to about 10 at%, about 1 at% to about 10 at%, 1 at% to about 8 at%, about 1 at% to about 5 at%, or about 1 at% to about 2 at%. The thickness of the third insulating layer 33 (e.g., the thickness thereof in the Z-axis direction) may be less than the thickness of the first insulating layer 31. In some example embodiments, the thickness of the third insulating layer 33 may be 0.5 times to 1.5 times the thickness of the second insulating layer 32. For example, the thickness of the third insulating layer 33 may be about 3 Å or less, for example, about 2 Å or less. For example, the thickness of the third insulating layer 33 (e.g., the thickness thereof in the Z-axis direction) may be about 0.01 Å to about 2 Å, about 0.1 Å to about 2 Å, about 1 Å to about 2 Å, about 1 Å to about 1.5 Å, or about 1 Å to about 1.1 Å. In some example embodiments, the third insulating layer 33 may be a single atomic layer. Thus, the threshold voltage of the semiconductor device 1 may be less affected by the third insulating layer 33, thereby improving the functionality and/or reliability of the semiconductor device 1.

The difference between the energy bandgap of the first insulating layer 31 and the energy bandgap of the third insulating layer 33 may be about 2 eV or more, for example about 2 eV to about 200 eV, about 2 eV to about 100 eV, about 2 eV to about 50 eV, about 2 eV to about 20 eV, about 2 eV to about 10 eV, or about 2 eV to about 5 eV. For example, the third insulating layer 33 may include a material having an energy bandgap of about 7 eV or more, for example about 7 eV to about 700 eV, about 7 eV to about 500 eV, about 7 eV to about 200 eV, about 7 eV to about 100 eV, about 7 eV to about 70 eV, about 7 eV to about 50 eV, about 7 eV to about 20 eV, or about 7 eV to about 10 eV. In another example, the third insulating layers 33 may include a material with a dielectric constant of about 20 or less, for example about 0.01 to about 20, about 0.1 to about 20, about 1 to about 20, about 1 to about 10, or about 1 to about 5. For example, the third insulating layer 33 may include an oxide including at least one of silicon (Si) or magnesium (Mg) (e.g., at least one of a silicon oxide or a magnesium oxide). Also, an energy bandgap difference between the second insulating layer 32 and the third insulating layer 33 may be 5 eV or more.

In FIG. 1, the gate insulating layer 30 is illustrated as including three first insulating layers 31, one second insulating layer 32, and one third insulating layer 33; however, the inventive concepts are not limited thereto. The gate insulating layer 30 may include a plurality of second insulating layers and a plurality of third insulating layers.

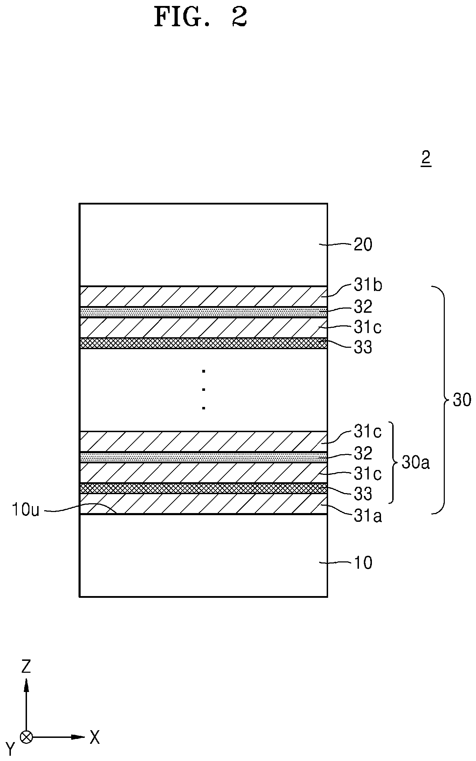

FIG. 2 is a diagram illustrating a semiconductor device 2 including a plurality of second insulating layers and a plurality of third insulating layers according to some example embodiments. Comparing FIG. 1 and FIG. 2, a gate insulating layer 30 of the semiconductor device 2 of FIG. 2 may include a plurality of second insulating layers 32 and a plurality of third insulating layers 33. The number (quantity) of the second insulating layers 32 may be equal to the number (quantity) of third insulating layers 33. The plurality of third insulating layers 33 and the plurality of second insulating layers 32 may be alternately arranged one by one in the thickness direction of the gate insulating layer 30 (e.g., in the Z-axis direction). Also, a first insulating layer 31c may be arranged between the third insulating layer 33 and the second insulating layer 32 adjacent to each other. For example, a first insulating layer 31c may be directly between an adjacent pair of layers that includes a third insulating layer 33 and a second insulating layer 32.

The number (quantity) of layers included in the gate insulating layer 30, which may be a sum of layers of the plurality of first insulating layers 31, one or more second insulating layers 32, and one or more third insulating layers 33, may be 4n+1 (where n is a natural number). For example, in the gate insulating layer 30, a layer in which a third insulating layer 33, a first insulating layer 31c, a second insulating layer 32, and a first insulating layer 31c are sequentially arranged in the thickness direction of the gate insulating layer 30 may be referred to as a set insulating layer 30a. The gate insulating layer 30 may include a plurality of set insulating layers 30a. For example, the gate insulating layer 30 may include a first insulating layer 31a, two or more set insulating layers 30a, a third insulating layer 33, a first insulating layer 31c, a second insulating layer 32, and a first insulating layer 31b. The thickness of each of first insulating layers 31a and 31b respectively adjacent to a gate electrode 20 and an oxide semiconductor layer 10 among a plurality of first insulating layers 31 may be greater than or equal to the thickness of a first insulating layer 31c arranged between a second insulating layer 32 and a third insulating layer 33.

The gate insulating layer 30 may include a plurality of set insulating layers 30a, thereby increasing the on-current of the oxide semiconductor layer 10 and further improving the reliability and/or functionality of the semiconductor device 2.

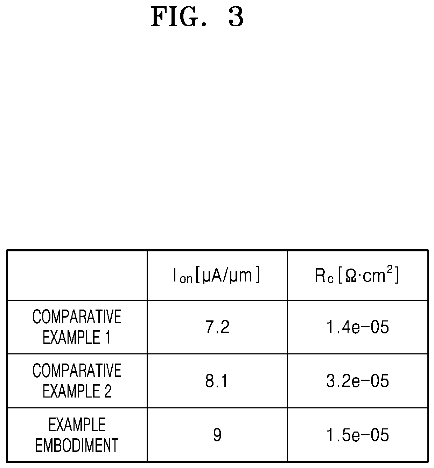

FIG. 3 is a diagram illustrating the result of measuring the performance of semiconductor devices including various types of insulating layers according to some example embodiments. Comparative Example 1 may be a semiconductor device including an insulating layer including only an aluminum oxide, and Comparative Example 2 may be a semiconductor device including an insulating layer including an aluminum oxide layer, a titanium oxide layer, and an aluminum oxide layer sequentially arranged therein. Also, the Example Embodiment indicated in FIG. 3 may be a semiconductor device according to some example embodiments, including the example embodiments shown in FIG. 1 and/or FIG. 2, and which may include a semiconductor device including an insulating layer including ten layers stacked therein. The insulating layer may include an aluminum oxide layer (e.g., a first insulating layer 31a) and three set insulating layers in the direction from an oxide semiconductor layer 10 to a gate electrode 20 (e.g., the thickness direction), and each set insulating layer may be a layer in which a silicon oxide layer (e.g., a third insulating layer 33), an aluminum oxide layer (e.g., a first insulating layer 31c), a titanium oxide layer (e.g., a second insulating layer 32), and an aluminum oxide layer (e.g., a first insulating layer 31c) are sequentially arranged in the direction from the oxide semiconductor layer 10 to the gate electrode 20 (e.g., the thickness direction). The semiconductor devices of Comparative Example 1, Comparative Example 2, and the Example Embodiment may be transistors.

Referring to FIG. 3, it may be seen that the on-current of Comparative Example 2, which is a semiconductor device further including a titanium oxide layer with a small energy bandgap, increases compared to that of Comparative Example 1, which is a semiconductor device including an insulating layer including only an aluminum oxide. However, in Comparative Example 2, it may be seen that the performance of the semiconductor device is degraded due to an increase in the contact resistance between a gate electrode 20 (here, the gate electrode 20 may be a source gate electrode 20 or a drain gate electrode 20) and an oxide semiconductor layer.

It may be seen that the on-current of the semiconductor device according to the Example Embodiment increases compared to the on-current of Comparative Example 1 including a single layer. In addition, it may be seen that the contact resistance is still low. The increase in the on-current may increase the contact resistance; however, it may be seen that the on-current may be increased while maintaining a low contact resistance by further arranging a silicon oxide layer with a high energy bandgap.

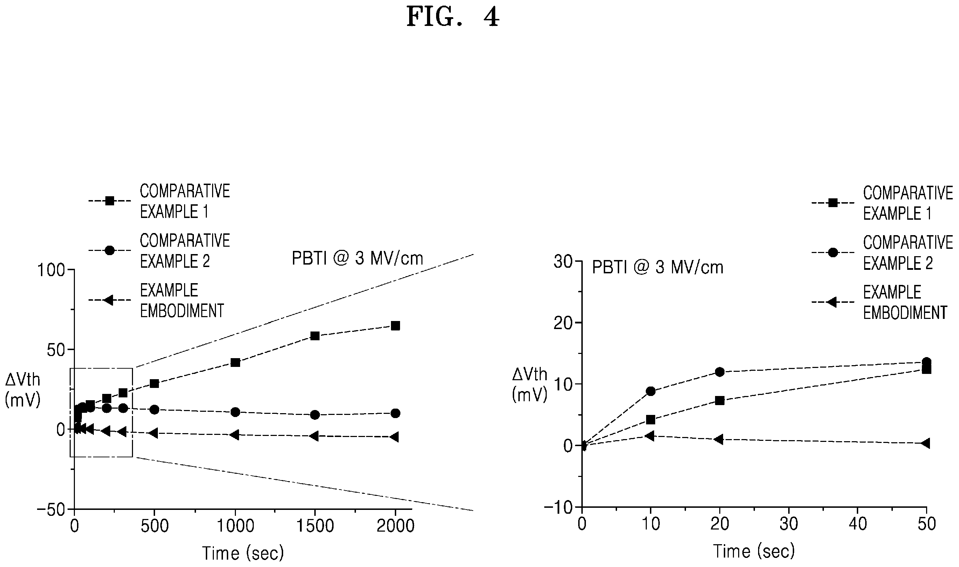

FIG. 4 is a diagram illustrating the result of measuring the positive bias temperature instability (PBTI) of a semiconductor device according to some example embodiments. In the semiconductor device of Comparative Example 2, it may be seen that an abnormal variation in the threshold voltage occurs within about 10 seconds after a positive gate voltage is applied thereto, and in the semiconductor device of Comparative Example 1, it may be seen that the threshold voltage increases over time after a positive gate voltage is applied thereto. However, in the semiconductor device of the Example Embodiment (which may be the Example Embodiment as described with reference to FIG. 3 and thus may include a semiconductor device according to some example embodiments, including the example embodiments shown in FIG. 1 and/or FIG. 2), it may be seen that almost no variation in the threshold voltage occurs even over time. This may mean that the semiconductor device according to the Example Embodiment (e.g., a semiconductor device according to some example embodiments) is reliable at a positive gate voltage, for example based on including one or more gate insulating layers that include a plurality of layers with different energy bandgaps.

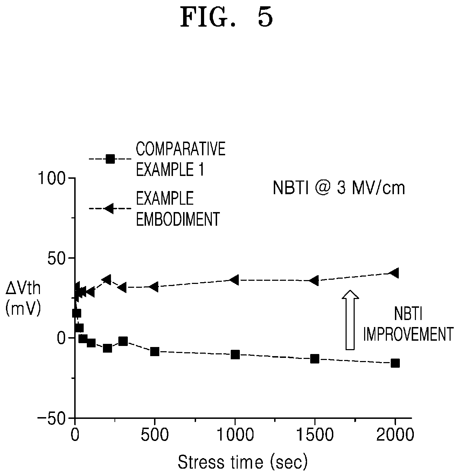

FIG. 5 is a diagram illustrating the result of measuring the negative bias temperature instability (NBTI) of a semiconductor device according to some example embodiments. In the semiconductor device of Comparative Example 1, it may be seen that the threshold voltage decreases over time after a negative gate voltage is applied thereto. However, in the semiconductor device of the Example Embodiment (which may be the Example Embodiment as described with reference to FIG. 3 and thus may include a semiconductor device according to some example embodiments, including the example embodiments shown in FIG. 1 and/or FIG. 2), it may be seen that the threshold voltage is maintained within a certain range even over time after a negative gate voltage is applied thereto. This may mean that the semiconductor device according to the Example Embodiment (e.g., a semiconductor device according to some example embodiments) is reliable at a negative gate voltage, for example based on including one or more gate insulating layers that include a plurality of layers with different energy bandgaps.

The semiconductor device described above may operate as a transistor. For example, the oxide semiconductor layer may have different oxygen concentrations depending on areas.

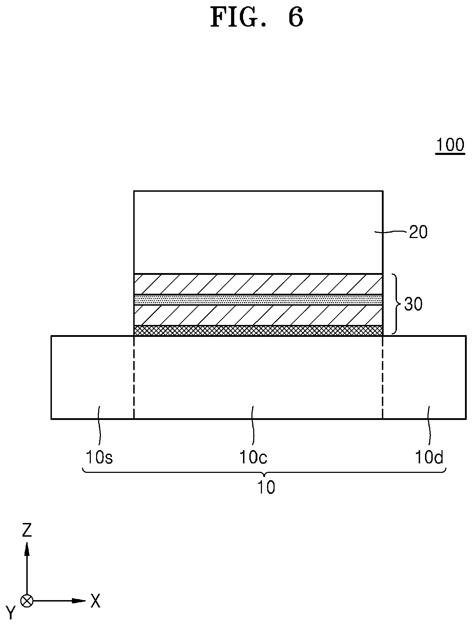

FIG. 6 is a diagram illustrating a semiconductor device 100 according to some example embodiments. Comparing FIG. 2 and FIG. 6, an oxide semiconductor layer 10 of FIG. 6 may include an area overlapping a gate electrode 20 in the thickness direction of a gate insulating layer 30 (e.g., the Z-axis direction) and an area not overlapping (e.g., exposed from) the gate electrode 20 in the thickness direction of a gate insulating layer 30 (e.g., the Z-axis direction). For example, the oxide semiconductor layer 10 may include a channel area 10c overlapping the gate electrode 20 in the thickness direction of the gate insulating layer 30, a source area 10s arranged at one end of the oxide semiconductor layer 10 and not overlapping the gate electrode 20 in the thickness direction of the gate insulating layer 30, and a drain area 10d arranged at the other end of the oxide semiconductor layer 10 and not overlapping the gate electrode 20 in the thickness direction of the gate insulating layer 30. That is, the channel area 10c may be located between the source area 10s and the drain area 10d. The gate electrode 20 and the gate insulating layer 30 shown in FIG. 6 may correspond to the gate electrode 20 and the gate insulating layer 30, respectively, according to any of the example embodiments, including the example embodiments shown in FIG. 1 or FIG. 2.

The oxygen content of the channel area 10c may be different from the oxygen content of the source area 10s and the drain area 10d. In the oxide semiconductor layer 10, carriers (e.g., free electrons) may be mainly generated by oxygen vacancies. Thus, the source area 10s and the drain area 10d may have a relatively high carrier density, that is, a relatively high oxygen vacancy density, in order to decrease the contact resistance. In some example embodiments, the channel area 10c may have a relatively low oxygen vacancy density in order to increase the threshold voltage and decrease the leakage current. In other words, the oxygen content in the channel area 10c may be higher than the oxygen content in the source area 10s and the drain area 10d. The gate electrode 20 of FIG. 6 may correspond to the gate electrode 20 described above, and the gate insulating layer 30 thereof may correspond to the gate insulating layer described above. The gate insulating layer 30 of FIG. 6 may correspond to the gate insulating layer 30 illustrated in FIG. 2; however, the inventive concepts are not limited thereto. The gate insulating layer 30 of FIG. 6 may correspond to the gate insulating layer 30 illustrated in FIG. 1. The gate electrode 20 has been described above with reference to FIG. 1, and thus, redundant descriptions thereof will be omitted for conciseness.

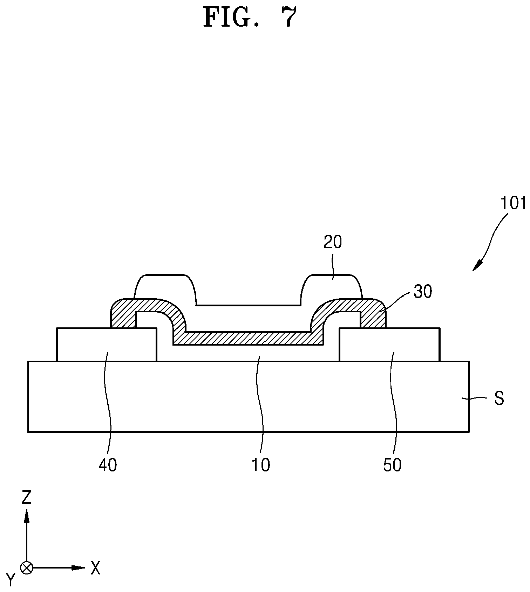

FIG. 7 is a diagram illustrating a semiconductor device 101 further including a plurality of gate electrodes 20 according to some example embodiments. Comparing FIG. 6 and FIG. 7, the semiconductor device 101 of FIG. 7 may further include a substrate S and a first electrode 40 and a second electrode 50 arranged apart from each other on the substrate S. The gate electrode 20 and a gate insulating layer 30 shown in FIG. 7 may correspond to the gate electrode 20 and the gate insulating layer 30, respectively, according to any of the example embodiments, including the example embodiments shown in FIG. 1 and/or FIG. 2. An oxide semiconductor layer 10 may have an oxygen content that is generally uniform or varies depending on areas.

The substrate S may be an insulating substrate or may be a semiconductor substrate with an insulating layer formed on a surface thereof. In some example embodiments, the substrate S may be a semiconductor substrate. The semiconductor substrate may include, for example, Si, Ge, SiGe, or a III-V group semiconductor material. The substrate S may be, for example, a silicon substrate with a silicon oxide formed on a surface thereof; however, the inventive concepts are not limited thereto.

The first electrode 40 and the second electrode 50 arranged on the substrate S may contact the oxide semiconductor layer 10. One of the first electrode 40 and the second electrode 50 may be a source electrode, and the other one may be a drain electrode.

The first electrode 40 and the second electrode 50 may include a metal material. The first electrode 40 and the second electrode 50 may include at least one selected from among tungsten (W), cobalt (Co), nickel (Ni), iron (Fe), titanium (Ti), molybdenum (Mo), chromium (Cr), zirconium (Zr), hafnium (Hf), niobium (Nb), tantalum (Ta), silver (Ag), gold (Au), aluminum (Al), copper (Cu), tin (Sb), vanadium (V), ruthenium (Ru), platinum (Pt), zinc (Zn), and magnesium (Mg).

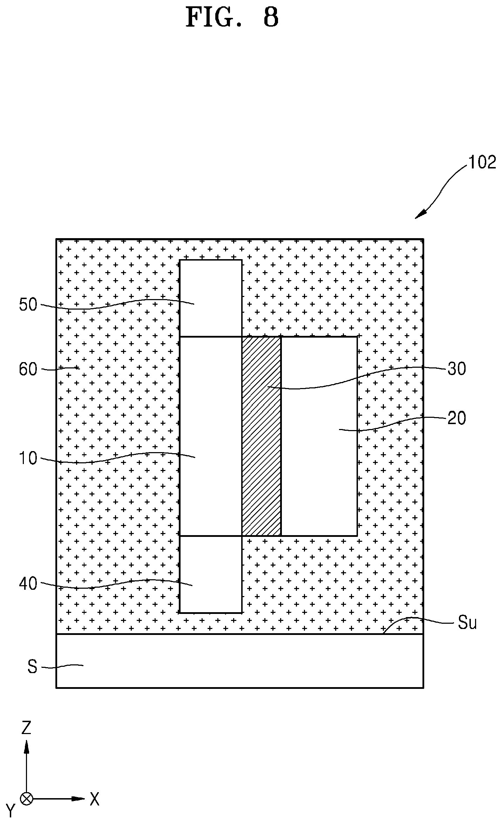

FIG. 8 is a diagram illustrating a semiconductor device 102 according to some example embodiments. Referring to FIG. 8, the semiconductor device 102 may include a substrate S, a first electrode 40 arranged over the substrate S, an oxide semiconductor layer 10 arranged on the first electrode 40, and a second electrode 50 arranged on the oxide semiconductor layer 10. The materials of the oxide semiconductor layer 10, the gate electrode 20, the gate insulating layer 30, the first electrode 40, and the second electrode 50 have been described above, and thus, redundant descriptions thereof will be omitted for conciseness.

The oxide semiconductor layer 10 may be arranged such that its lengthwise direction is in a direction perpendicular to the substrate S (Z-axis direction). Herein, the lengthwise direction may refer to a direction in which the length of the component is long when viewed in the drawing.

The first electrode 40 and the second electrode 50 may be arranged apart from each other in a direction perpendicular to the substrate S (Z-axis direction extending perpendicular to a surface Su of the substrate S facing at least the first electrode 40 and the second electrode 50). For example, the first electrode 40, the oxide semiconductor layer 10, and the second electrode 50 may be arranged in a line in a direction perpendicular to the substrate S or in the thickness direction of the first electrode 40 (in the Z-axis direction).

The gate electrode 20 may be arranged on one side of the oxide semiconductor layer 10. The gate electrode 20 may correspond to the gate electrode 20 described above. The gate insulating layer 30 may be arranged between the oxide semiconductor layer 10 and the gate electrode 20. The gate electrode 20 may be arranged such that its lengthwise direction (Z-axis direction) is perpendicular to the substrate S. The oxide semiconductor layer 10, the gate insulating layer 30, and the gate electrode 20 may be arranged in a line in a direction parallel to the substrate S (X-axis direction extending parallel to the surface Su of the substrate S facing at least the first electrode 40 and the second electrode 50).

A mold insulating layer 60 may be arranged on the substrate S to fill an empty space thereof. The first electrode 40 may be arranged apart from the substrate S by the mold insulating layer 60.

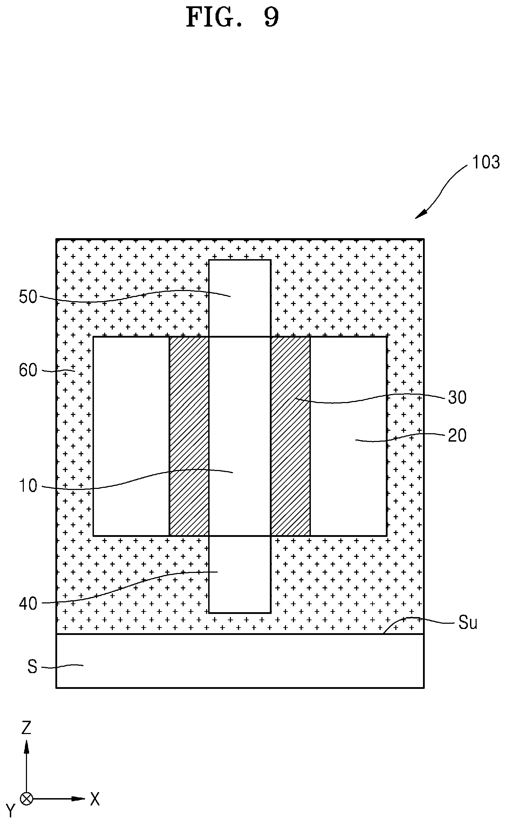

FIG. 9 is a diagram illustrating a semiconductor device 103 according to some example embodiments. In FIG. 9, components denoted by the same reference numbers as those in FIG. 8 may have the same or substantially the same configurations and effects as those described above with reference to FIG. 8, and thus, redundant descriptions thereof will be omitted for conciseness.

The semiconductor device 103 illustrated in FIG. 9 may include a first electrode 40, an oxide semiconductor layer 10, and a second electrode 50 arranged in a direction perpendicular to the substrate S (Z-axis direction). A gate insulating layer 30 may be arranged around the oxide semiconductor layer 10, and a gate electrode 20 may be arranged around the gate insulating layer 30. The gate electrode 20 may be arranged around the oxide semiconductor layer 10 to increase the area where the gate electrode 20 and the oxide semiconductor layer 10 face each other and may improve the short channel effect.

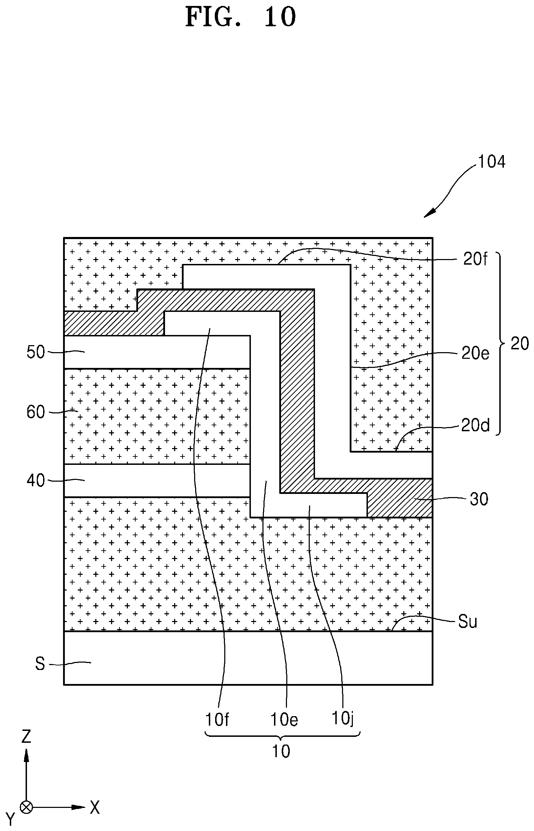

FIG. 10 is a diagram illustrating a semiconductor device 104 according to some example embodiments. In FIG. 10, components denoted by the same reference numbers as those in FIG. 9 may have substantially the same configurations and effects as those described above with reference to FIG. 9, and thus, redundant descriptions thereof will be omitted for conciseness.

Referring to FIG. 10, the semiconductor device 104 may include a substrate S, a first electrode 40 arranged over the substrate S, and a second electrode 50 arranged apart from the first electrode 40. The first electrode 40 and the second electrode 50 may be arranged apart from each other in a direction perpendicular to the substrate S (Z-axis direction extending perpendicular to a surface Su of the substrate S facing at least the first electrode 40 and the second electrode 50).

An oxide semiconductor layer 10 may be arranged at the outside between the first electrode 40 and the second electrode 50. The oxide semiconductor layer 10 may include a first portion 10j parallel to the substrate S (e.g., in the +X-axis direction), a second portion 10e bending and extending from the first portion 10j in a perpendicular direction to the substrate S (e.g., in the Z-axis direction), and a third portion 10f bending and extending from the second portion 10e in an opposite direction to the first portion 10j (e.g., in the -X-axis direction). The second portion 10e may be arranged on the side portion of the first electrode 40 and the second electrode 50, and the third portion 10f may be arranged to contact the second electrode 50.

The gate electrode 20 may have a similar shape to the oxide semiconductor layer 10 and may be arranged apart from the oxide semiconductor layer 10. In other words, the gate electrode 20 may include a first portion 20d parallel to the substrate S (e.g., in the +X-axis direction), a second portion 20e bending and extending from the first portion 20d in a perpendicular direction to the substrate S (e.g., in the Z-axis direction), and a third portion 20f bending and extending from the second portion 20e in an opposite direction to the first portion 20d (e.g., in the -X-axis direction). A gate insulating layer 30 may be arranged between the oxide semiconductor layer 10 and the gate electrode 20.

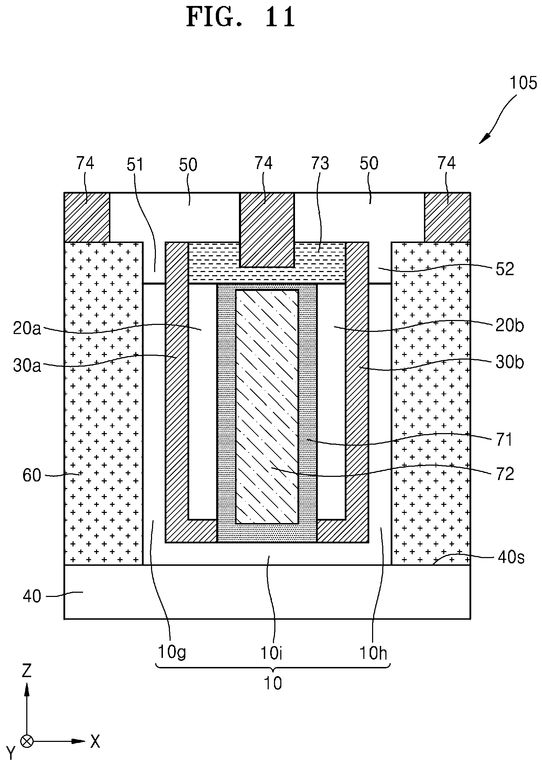

FIG. 11 is a diagram illustrating a semiconductor device 105 according to some example embodiments. In FIG. 11, the same components as the reference numbers described above may have the same configurations and effects as the reference numbers described above, and thus, redundant descriptions thereof will be omitted for conciseness.

The semiconductor device 105 illustrated in FIG. 11 may include a first electrode 40 and an oxide semiconductor layer 10 arranged on the first electrode 40. The oxide semiconductor layer 10 may have a U-shaped cross-sectional shape. The oxide semiconductor layer 10 may include a bottom portion 10i contacting the first electrode 40, a first vertical extension portion 10g extending from one end of the bottom portion 10i in a direction perpendicular to the first electrode 40 (Z-axis direction extending perpendicular to a surface 40s of the first electrode 40 facing the oxide semiconductor layer 10), and a second vertical extension portion 10h extending from the other end of the bottom portion 10i in a direction perpendicular to the first electrode 40 (Z-axis direction).

A first gate electrode 20a may be arranged apart from the first vertical extension portion 10g, and a second gate electrode 20b may be arranged apart from the second vertical extension portion 10h. A first gate insulating layer 30a may be arranged between the first vertical extension portion 10g and the first gate electrode 20a, and a second gate insulating layer 30b may be arranged between the second vertical extension portion 10h and the second gate electrode 20b.

The first gate electrode 20a and/or the second gate electrode 20b may extend in a second horizontal direction (Y-axis direction). The first gate electrode 20a and the second gate electrode 20b may be located apart from each other. The first gate electrode 20a and/or the second gate electrode 20b may constitute a word line. An electrical signal input to the first gate electrode 20a may not correspond to an electrical signal input to the second gate electrode 20b. The first gate electrode 20a may control a channel of the first vertical extension portion 10g, and the second gate electrode 20b may control a channel of the second vertical extension portion 10h.

An insulating liner 71 may be arranged between the first gate electrode 20a and the second gate electrode 20b spaced apart from each other. The insulating liner 71 may be conformally arranged on the sidewalls of the first gate electrode 20a and the second gate electrode 20b facing each other and/or the upper surface of the oxide semiconductor layer 10. The insulating liner 71 may have an upper surface arranged on the same plane as the first gate electrode 20a and the second gate electrode 20b. The insulating liner 71 may include, for example, a silicon nitride. A buried insulating layer 72 may fill the space between the first gate electrode 20a and the second gate electrode 20b spaced apart from each other on the insulating liner 71. The buried insulating layer 72 may include, for example, a silicon oxide. An upper insulating layer 73 may be arranged on the upper surface of the first gate electrode 20a, the second gate electrode 20b, and/or the buried insulating layer 72. The upper surface of the upper insulating layer 73 may be arranged on the same level as the upper surface of a mold insulating layer 60.

A second electrode 50 may be arranged over the oxide semiconductor layer 10. The second electrode 50 may function as a landing pad. The second electrode 50 may include a first subelectrode 51 and a second subelectrode 52. The first subelectrode 51 may be electrically connected to the first vertical extension portion 10g. The second subelectrode 52 may be electrically connected to the second vertical extension portion 10h. The first subelectrode 51 and the second subelectrode 52 may not be electrically connected to each other.

The second electrode 50 may include an upper portion and a lower portion. The upper portion of the second electrode 50 may be a portion of the second electrode 50 arranged at a level higher than the upper surface of the mold insulating layer 60. The lower portion of the second electrode 50 may be a portion of the second electrode 50 arranged in an electrode recess defined between the mold insulating layer 60 and the upper insulating layer 73.

In some example embodiments, the upper portion of the second electrode 50 may have a first width in a first horizontal direction (X-axis direction), and the lower portion of the second electrode 50 may have a second width less than the first width in the first horizontal direction (X-axis direction). The lower portion of the second electrode 50 may be arranged in the electrode recess, and the upper portion of the second electrode 50 may have a bottom surface arranged on the upper surface of the mold insulating layer 60 and the upper surface of the upper insulating layer 73 on the lower portion of the second electrode 50, and accordingly, the second electrode 50 may have a T-shaped vertical cross-section.

The bottom surface of the lower portion of the second electrode 50 may contact the upper surface of the first vertical extension portion 10g and/or the second vertical extension portion 10h. Both sidewalls of the lower portion of the second electrode 50 may be aligned with both sidewalls of the first vertical extension portion 10g and the second vertical extension portion 10h. The bottom surface of the lower portion of the second electrode 50 may be arranged at a level higher than the upper surface of the first gate electrode 20a and/or the second gate electrode 20b, and a portion of the sidewall of the lower portion of the second electrode 50 may be covered by the first gate insulating layer 30a and/or the second gate insulating layer 30b.

An insulating layer 74 surrounding the periphery of the second electrode 50 may be arranged on the upper surface of the mold insulating layer 60 and the upper insulating layer 73. The semiconductor device 105 may have a vertical channel transistor (VCT) structure including a vertical channel area extending in a perpendicular direction to the first electrode 40 (Z-axis direction).

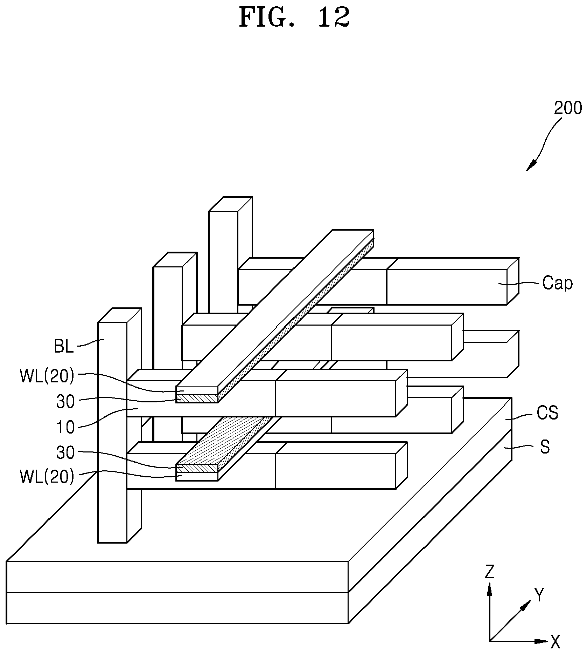

A semiconductor device according to some example embodiments may be a component of a memory device. FIG. 12 is a perspective view illustrating a schematic structure of a vertical stack memory device 200 according to some example embodiments. Referring to FIG. 12, the vertical stack memory device 200 may include a plurality of bit lines BL extending in a first direction (i.e., Z direction), a plurality of oxide semiconductor layers 10 respectively connected to the plurality of bit lines BL and extending in a second direction (i.e., X direction) perpendicularly intersecting the first direction, a plurality of capacitors Cap respectively electrically connected to the plurality of oxide semiconductor layers 10, and a plurality of word lines WL extending to intersect the plurality of oxide semiconductor layers 10 in a third direction (i.e., Y direction) perpendicularly intersecting the first direction and the second direction. In FIG. 12, each of the plurality of word lines WL is illustrated as intersecting over corresponding oxide semiconductor layers 10 among the plurality of oxide semiconductor layers 10; however, the inventive concepts are not limited thereto and each of the plurality of word lines WL may intersect under the corresponding oxide semiconductor layers 10.

Also, the vertical stack memory device 200 may further include a growth substrate S and a driving circuit substrate CS arranged over the growth substrate S. The driving circuit substrate CS may include circuits connected to an external circuit to perform an input/output operation of receiving data from the outside or outputting data to the outside and an operation of writing data into the capacitor Cap or reading data written into the capacitor Cap.

The plurality of bit lines BL may be arranged over the driving circuit substrate CS so as to be perpendicular to the upper surface of the driving circuit substrate CS. For convenience, FIG. 12 illustrates that only three bit lines BL are arranged in a line at intervals in the third direction; however, in actuality, a larger number of bit lines BL may be two-dimensionally arranged. For example, a plurality of bit lines BL extending in the vertical direction, i.e., the first direction, may be two-dimensionally arranged over the driving circuit substrate CS at certain intervals in the second direction and the third direction. The plurality of bit lines BL may be arranged in parallel to each other.

A plurality of oxide semiconductor layers 10 connected to a corresponding bit line BL among the plurality of bit lines BL may be arranged at certain intervals in the first direction. In FIG. 12, for convenience, only two oxide semiconductor layers 10 are illustrated for one bit line BL; however, a larger number of oxide semiconductor layers 10 may be arranged at certain intervals in the first direction. Also, in the same layer, a plurality of oxide semiconductor layers 10 may be arranged in parallel to each other at certain intervals in the third direction. A plurality of oxide semiconductor layers 10 arranged on the same layer may be respectively connected to different corresponding bit lines among the plurality of bit lines BL. Like the plurality of bit lines BL, the plurality of oxide semiconductor layers 10 may also be two-dimensionally arranged at certain intervals in the second direction and the third direction. Each of the plurality of oxide semiconductor layers 10 may extend in the second direction. A first end portion of each of the plurality of oxide semiconductor layers 10 may be electrically connected to a corresponding bit line among the plurality of bit lines BL. A second end portion of each of the plurality of oxide semiconductor layers 10, which is opposite to the first end portion in the second direction, may be electrically connected to the capacitor Cap.

In FIG. 12, for convenience, the capacitor Cap is illustrated as a single block; however, in actuality, the capacitor Cap may include a first electrode, a second electrode, and a dielectric layer arranged between the first electrode and the second electrode. The first electrode of the capacitor Cap may be electrically connected to the second end portion of the corresponding oxide semiconductor layer 10 among the plurality of oxide semiconductor layers 10. Thus, one oxide semiconductor layer 10 and one capacitor Cap may be one-to-one connected to each other. Although not illustrated, the second electrode of the capacitor Cap may be connected to a ground line of the vertical stack memory device 200.

The word line WL may extend in the third direction to intersect over a plurality of corresponding oxide semiconductor layers 10. Also, a plurality of word lines WL may be arranged at intervals in the first direction. For convenience, FIG. 12 illustrates that only one word line WL is arranged on one layer; however, a plurality of word lines WL may be arranged on one layer in parallel to each other at intervals in the second direction.

A gate insulating layer 30 may be arranged between the oxide semiconductor layer 10 and the word line WL. Although not illustrated in FIG. 12 for convenience, the vertical stack memory device 200 may further include an insulating material filling the space between the plurality of bit lines BL, between the plurality of oxide semiconductor layers 10, and between the plurality of word lines WL.

One oxide semiconductor layer 10 may form one oxide semiconductor transistor together with one word line WL corresponding thereto. The word line WL may function as a gate electrode 20 of the oxide semiconductor transistor. When a gate signal higher than the threshold voltage is applied to the word line WL, a current may flow along the channel area 10c. Then, the bit line BL and the capacitor Cap corresponding to each other may be electrically connected to each other, and thus, data may be written into the capacitor Cap or data written into the capacitor Cap may be read.

Thus, one oxide semiconductor layer 10 and one capacitor Cap corresponding thereto may form one memory cell. The vertical stack memory device 200 according to some example embodiments may include a plurality of memory cells two-dimensionally arranged on one layer. Also, the vertical stack memory device 200 may have a structure in which a plurality of layers including a plurality of two-dimensionally arranged memory cells are stacked. Thus, because the integration degree of memory cells is high, the recording capacity of the vertical stack memory device 200 may be improved.

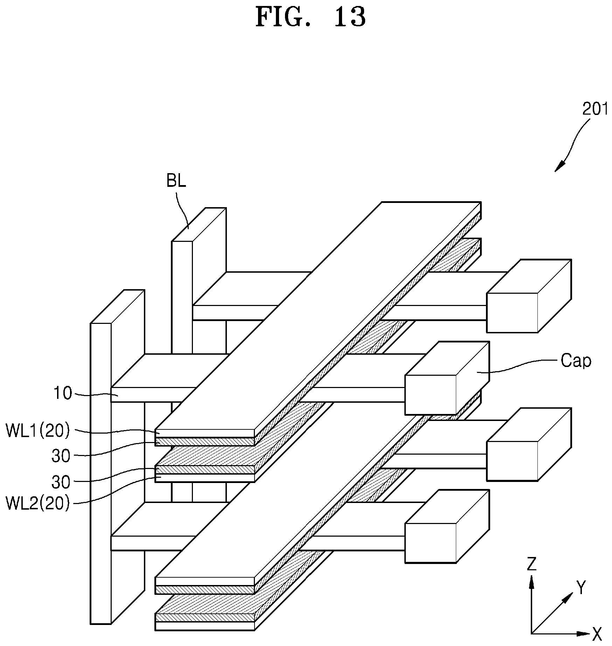

FIG. 13 is a perspective view illustrating a schematic structure of a vertical stack memory device 201 according to some example embodiments. Referring to FIGS. 12 and 13, the vertical stack memory device 201 of FIG. 13 may have a dual-gate structure. For example, the vertical stack memory device 201 may include a first word line WL1 (e.g., corresponding to a gate electrode 20) extending in a third direction to intersect over a plurality of oxide semiconductor layers 10 arranged on the same layer, and a second word line WL2 (e.g., corresponding to another gate electrode 20) extending in the third direction to intersect under the plurality of oxide semiconductor layers 10 arranged on the same layer. The first word line WL1 and the second word line WL2 may be spaced apart from each other in a first direction with the corresponding oxide semiconductor layers 10 therebetween and may be arranged to face each other in parallel to each other. In other words, it may be considered that each of the plurality of word lines WL illustrated in FIG. 12 includes a first word line WL1 and a second word line WL2 that are spaced apart from each other in the first direction with the corresponding oxide semiconductor layers 10 among the plurality of oxide semiconductor layers 10 therebetween and are arranged to face each other in parallel to each other.

One oxide semiconductor layer 10 may form one oxide semiconductor transistor together with the first word line WL1 and the second word line WL2 corresponding thereto. The operation of one oxide semiconductor transistor may be controlled together by the first word line WL1 arranged over the oxide semiconductor layer 10 and the second word line WL2 arranged under the oxide semiconductor layer 10. Thus, the driving reliability of the oxide semiconductor transistor may be improved. Other components of the vertical stack memory device 201 illustrated in FIG. 13 may be the same as those of the vertical stack memory device 200 illustrated in FIG. 12, and thus, redundant descriptions thereof will be omitted for conciseness.

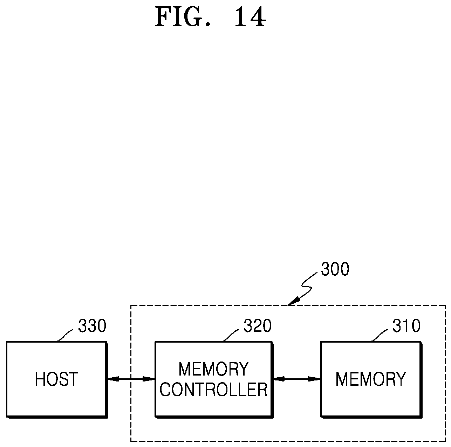

FIG. 14 is a block diagram illustrating an electronic system 300 according to some example embodiments.

The electronic system 300 may include a memory 310 and a memory controller 320. The memory controller 320 may control the memory 310 to read data from the memory 310 and/or write data into the memory 310 in response to a request from a host 330. At least one of the memory 310 and the memory controller 320 may include the semiconductor device according to some example embodiments described above.

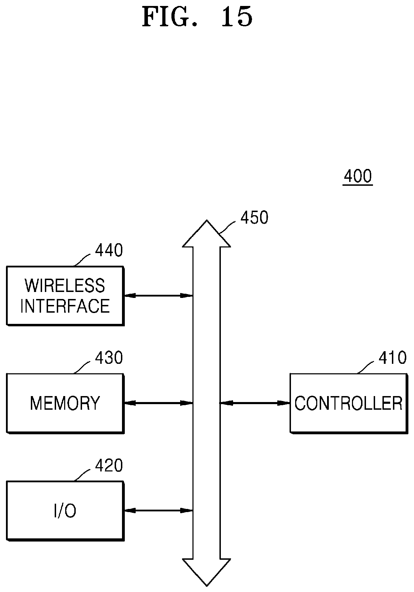

FIG. 15 is a block diagram of an electronic system 400 according to some example embodiments.

The electronic system 400 may configure a wireless communication apparatus or an apparatus capable of transmitting and/or receiving information in a wireless environment. The electronic system 400 may include a controller 410, an input/output (I/O) device 420, a memory 430, and a wireless interface 440, which may be connected to each other through a bus 450.

The controller 410 may include at least one of a microprocessor, a digital signal processor, or any similar processors. The I/O device 420 may include at least one of a keypad, a keyboard, or a display. The memory 430 may be used to store a command executed by the controller 410. For example, the memory 430 may be used to store user data. The electronic system 400 may use the wireless interface 440 to transmit/receive data through a wireless communication network. The wireless interface 440 may include an antenna and/or a wireless transceiver. The electronic system 400 may include the semiconductor device according to some example embodiments described above.

The semiconductor device according to some example embodiments may include a gate insulating layer including a plurality of insulating layers with different energy bandgaps stacked therein, thus increasing the on-current value thereof and also improving the reliability and/or functionality thereof.

The semiconductor device according to some example embodiments may include a gate insulating layer including a plurality of layers with different energy bandgaps stacked therein, thereby increasing the on-current value of the semiconductor device, and thereby improving the functionality and/or reliability of the semiconductor device.

The semiconductor device according to some example embodiments may include a gate insulating layer including a plurality of layers with different energy bandgaps stacked therein, thereby maintaining the reliability of the semiconductor device even when the operation time of the semiconductor device becomes longer.

The semiconductor device according to some example embodiments may be used in a high-integration memory device, a logic device, or the like by including an insulating layer including a plurality of layers with different energy bandgaps stacked therein.

As described herein, any devices, systems, modules, portions, units, controllers, circuits, and/or portions thereof according to any of the example embodiments, and/or any portions thereof (including, without limitation, the electronic system 300, the memory 310, the memory controller 320, the host 330, the electronic system 400, the controller 410, the input/output (I/O) device 420, the memory 430, the wireless interface 440, any portion thereof, or the like) may include, may be included in, and/or may be implemented by one or more instances of processing circuitry such as hardware including logic circuits; a hardware/software combination such as a processor executing software; or a combination thereof. For example, the processing circuitry more specifically may include, but is not limited to, a central processing unit (CPU), an arithmetic logic unit (ALU), a graphics processing unit (GPU), an application processor (AP), a digital signal processor (DSP), a microcomputer, a field programmable gate array (FPGA), and programmable logic unit, a microprocessor, application-specific integrated circuit (ASIC), a neural network processing unit (NPU), an Electronic Control Unit (ECU), an Image Signal Processor (ISP), and the like. In some example embodiments, the processing circuitry may include a non-transitory computer readable storage device (e.g., a memory), for example a solid state drive (SSD), storing a program of instructions, and a processor (e.g., CPU) configured to execute the program of instructions to implement the functionality and/or methods performed by some or all of any devices, systems, modules, portions, units, controllers, circuits, and/or portions thereof according to any of the example embodiments.

It should be understood that example embodiments described herein should be considered in a descriptive sense only and not for purposes of limitation. Descriptions of features or aspects within each example embodiment should typically be considered as available for other similar features or aspects in some example embodiments. While some example embodiments have been described with reference to the figures, it will be understood by those of ordinary skill in the art that various changes in form and details may be made therein without departing from the scope as defined by the following claims.

## Claims

1. A semiconductor device (1), comprising:
an oxide semiconductor layer (10);
a gate electrode (20) arranged apart from the oxide semiconductor layer; and
a gate insulating layer (30) arranged between the oxide semiconductor layer and the gate electrode,
wherein the gate insulating layer includes
a plurality of first insulating layers (31) arranged apart from each other in a thickness direction of the gate insulating layer,
a second insulating layer (32) arranged between a first set of adjacent first insulating layers among the plurality of first insulating layers, the second insulating layer having a smaller energy bandgap than each first insulating layer of the plurality of first insulating layers, and
a third insulating layer (33) arranged between a second set of adjacent first insulating layers among the plurality of first insulating layers, the third insulating layer having a greater energy bandgap than each first insulating layer of the plurality of first insulating layers, and
wherein the third insulating layer is closer to the oxide semiconductor layer than the second insulating layer.

2. The semiconductor device of claim 1, wherein a content of at least one of the second insulating layer and third insulating layer in the gate insulating layer is 10 at% or less.

3. The semiconductor device of claim 1 or 2, wherein
the plurality of first insulating layers include two outermost first insulating layers (31a, 31c) among the plurality of first insulating layers in the thickness direction of the gate insulating layer and at least one inner first insulating layer (31c) between the two outermost first insulating layers, and
a thickness in the thickness direction of the gate insulating layer of each of the two outermost first insulating layers among the plurality of first insulating layers is greater than or equal to a thickness in the thickness direction of the gate insulating layer of the at least one inner first insulating layer among the plurality of first insulating layers, and optionally wherein one of the two outermost first insulating layers either contacts the oxide semiconductor layer or contacts the gate electrode.

4. The semiconductor device of any preceding claim, wherein a first insulating layer among the plurality of first insulating layers is arranged between the second insulating layer and the third insulating layer.

5. The semiconductor device of any preceding claim, wherein a thickness of each first insulating layer of the plurality of first insulating layers in the thickness direction of the gate insulating layer is greater than a thickness of each layer of the second insulating layer and the third insulating layer in the thickness direction of the gate insulating layer.

6. The semiconductor device of any preceding claim, wherein a thickness of at least one of the second insulating layer or the third insulating layer in the thickness direction of the gate insulating layer is 3Å or less.

7. The semiconductor device of any preceding claim, wherein a thickness of each first insulating layer of the plurality of first insulating layers in the thickness direction of the gate insulating layer is 5Å or more.

8. The semiconductor device of any preceding claim, wherein a thickness of the gate insulating layer in the thickness direction of the gate insulating layer is 3 nm to 10 nm.

9. The semiconductor device of any preceding claim, wherein a sum of layers of the plurality of first insulating layers, the second insulating layer, and the third insulating layer is 4n+1, where n is a natural number.

10. The semiconductor device of any preceding claim, wherein,
the second insulating layer includes a plurality of second insulating layers,
the third insulating layer includes a plurality of third insulating layers, and
the plurality of second insulating layers and the plurality of third insulating layers are alternately arranged one by one in the thickness direction of the gate insulating layer.

11. The semiconductor device of any preceding claim, wherein an energy bandgap difference between the second insulating layer and the third insulating layer is 5 eV or more.

12. The semiconductor device of any preceding claim, wherein the third insulating layer comprises an oxide comprising at least one of silicon (Si) or magnesium (Mg).

13. The semiconductor device of any preceding claim, wherein the second insulating layer comprises at least one of titanium (Ti) or hafnium (Hf).

14. The semiconductor device of any preceding claim, wherein an energy bandgap difference between a first insulating layer among the plurality of first insulating layers and at least one of the second insulating layer or the third insulating layer is 2 eV or more.

15. The semiconductor device of any preceding claim, wherein the plurality of first insulating layers each independently include an oxide, the oxide comprising at least one of aluminum (Al), calcium (Ca), yttrium (Y), zirconium (Zr), or hafnium (Hf).

## Patentansprüche

1. Halbleiteranordnung (1), umfassend:
eine Oxidhalbleiterschicht (10);
eine Gate-Elektrode (20), die getrennt von der Oxidhalbleiterschicht arrangiert ist; und
eine Gate-Isolierschicht (30), die zwischen der Oxidhalbleiterschicht und der Gate-Elektrode arrangiert ist,
wobei die Gate-Isolierschicht eine Vielzahl von ersten Isolierschichten (31), die beabstandet voneinander in einer Dickenrichtung der Gate-Isolierschicht arrangiert ist, eine zweite Isolierschicht (32), die zwischen einem ersten Satz von benachbarten ersten Isolierschichten unter der Vielzahl von ersten Isolierschichten arrangiert ist, wobei die zweite Isolierschicht eine kleinere Energiebandlücke als jede erste Isolierschicht aus der Vielzahl von ersten Isolierschichten aufweist, und eine dritte Isolierschicht (33), die zwischen einem zweiten Satz von benachbarten ersten Isolierschichten unter der Vielzahl von ersten Isolierschichten arrangiert ist, beinhaltet, wobei die dritte Isolierschicht eine größere Energiebandlücke als jede erste Isolierschicht aus der Vielzahl von ersten Isolierschichten aufweist, und
wobei die dritte Isolierschicht näher an der Oxidhalbleiterschicht als die zweite Isolierschicht ist.

2. Halbleiteranordnung nach Anspruch 1, wobei ein Gehalt von zumindest einer von der zweiten Isolierschicht und der dritten Isolierschicht in der Gate-Isolierschicht 10 At.-% oder weniger ist.

3. Halbleiteranordnung nach Anspruch 1 oder 2, wobei
die Vielzahl von ersten Isolierschichten zwei äußerste erste Isolierschichten (31a, 31c) unter der Vielzahl von ersten Isolierschichten in der Dickenrichtung der Gate-Isolierschicht und zumindest eine innere erste Isolierschicht (31c) zwischen den zwei äußersten ersten Isolierschichten beinhaltet, und
eine Dicke in der Dickenrichtung der Gate-Isolierschicht von jeder von den zwei äußersten ersten Isolierschichten unter der Vielzahl von ersten Isolierschichten größer als eine oder gleich einer Dicke in der Dickenrichtung der Gate-Isolierschicht der zumindest einen inneren ersten Isolierschicht unter der Vielzahl von ersten Isolierschichten ist und wobei optional eine von den zwei äußersten ersten Isolierschichten entweder die Oxidhalbleiterschicht kontaktiert oder die Gate-Elektrode kontaktiert.

4. Halbleiteranordnung nach einem vorhergehenden Anspruch, wobei eine erste Isolierschicht unter der Vielzahl von ersten Isolierschichten zwischen der zweiten Isolierschicht und der dritten Isolierschicht arrangiert ist.

5. Halbleiteranordnung nach einem vorhergehenden Anspruch, wobei eine Dicke von jeder ersten Isolierschicht aus der Vielzahl von ersten Isolierschichten in der Dickenrichtung der Gate-Isolierschicht größer als eine Dicke von jeder Schicht der zweiten Isolierschicht und der dritten Isolierschicht in der Dickenrichtung der Gate-Isolierschicht ist.

6. Halbleiteranordnung nach einem vorhergehenden Anspruch, wobei eine Dicke von zumindest einer von der zweiten Isolierschicht oder der dritten Isolierschicht in der Dickenrichtung der Gate-Isolierschicht 3Å oder weniger ist.

7. Halbleiteranordnung nach einem vorhergehenden Anspruch, wobei eine Dicke von jeder ersten Isolierschicht aus der Vielzahl von ersten Isolierschichten in der Dickenrichtung der Gate-Isolierschicht 5Å oder mehr ist.

8. Halbleiteranordnung nach einem vorhergehenden Anspruch, wobei eine Dicke der Gate-Isolierschicht in der Dickenrichtung der Gate-Isolierschicht 3 nm bis 10 nm ist.

9. Halbleiteranordnung nach einem vorhergehenden Anspruch, wobei eine Summe von Schichten der Vielzahl von ersten Isolierschichten, der zweiten Isolierschicht und der dritten Isolierschicht 4n+1 ist, wobei n eine natürliche Zahl ist.

10. Halbleiteranordnung nach einem vorhergehenden Anspruch, wobei
die zweite Isolierschicht eine Vielzahl von zweiten Isolierschichten beinhaltet,
die dritte Isolierschicht eine Vielzahl von dritten Isolierschichten beinhaltet, und
die Vielzahl von zweiten Isolierschichten und die Vielzahl von dritten Isolierschichten abwechselnd eine nach der anderen in der Dickenrichtung der Gate-Isolierschicht arrangiert sind.

11. Halbleiteranordnung nach einem vorhergehenden Anspruch, wobei eine Energiebandlückendifferenz zwischen der zweiten Isolierschicht und der dritten Isolierschicht 5 eV oder mehr ist.

12. Halbleiteranordnung nach einem vorhergehenden Anspruch, wobei die dritte Isolierschicht ein Oxid umfasst, das zumindest eines von Silizium (Si) oder Magnesium (Mg) umfasst.

13. Halbleiteranordnung nach einem vorhergehenden Anspruch, wobei die zweite Isolierschicht zumindest eines von Titan (Ti) oder Hafnium (Hf) umfasst.

14. Halbleiteranordnung nach einem vorhergehenden Anspruch, wobei eine Energiebandlückendifferenz zwischen einer ersten Isolierschicht unter der Vielzahl von ersten Isolierschichten und zumindest einer von der zweiten Isolierschicht oder der dritten Isolierschicht 2 eV oder mehr ist.

15. Halbleiteranordnung nach einem vorhergehenden Anspruch, wobei die Vielzahl von ersten Isolierschichten jeweils unabhängig ein Oxid beinhaltet, wobei das Oxid zumindest eines von Aluminium (Al), Calcium (Ca), Yttrium (Y), Zirkonium (Zr) oder Hafnium (Hf) umfasst.

## Revendications

1. Dispositif semi-conducteur (1) comprenant :
une couche de semi-conducteur à oxyde (10) ;
une électrode de grille (20) disposée à l'écart de la couche de semi-conducteur à oxyde ; et
une couche isolante de grille (30) disposée entre la couche de semi-conducteur à oxyde et l'électrode de grille,
ladite couche isolante de grille comprenant une pluralité de premières couches isolantes (31) disposées à distance les unes des autres dans le sens de l'épaisseur de la couche isolante de grille,
une deuxième couche isolante (32) disposée entre un premier ensemble de premières couches isolantes adjacentes parmi la pluralité de premières couches isolantes, la deuxième couche isolante comportant une bande interdite d'énergie plus petite que chaque première couche isolante de la pluralité de premières couches isolantes, et
une troisième couche isolante (33) disposée entre un second ensemble de premières couches isolantes adjacentes parmi la pluralité de premières couches isolantes, la troisième couche isolante comportant une bande interdite d'énergie plus grande que chaque première couche isolante de la pluralité de premières couches isolantes, et
ladite troisième couche isolante étant plus proche de la couche de semi-conducteur à oxyde que la deuxième couche isolante.

2. Dispositif semi-conducteur selon la revendication 1, la teneur d'au moins une couche parmi la deuxième couche isolante et la troisième couche isolante dans la couche isolante de grille étant inférieure ou égale à 10 % at.

3. Dispositif semi-conducteur selon la revendication 1 ou 2,
ladite pluralité de premières couches isolantes comprenant les deux premières couches isolantes les plus externes (31a, 31c) parmi la pluralité de premières couches isolantes dans le sens de l'épaisseur de la couche isolante de grille et au moins une première couche isolante interne (31c) entre les deux premières couches isolantes les plus externes, et
l'épaisseur dans le sens de l'épaisseur de la couche isolante de grille de chacune des deux premières couches isolantes les plus externes parmi la pluralité de premières couches isolantes étant supérieure ou égale à l'épaisseur dans le sens de l'épaisseur de la couche isolante de grille de ladite au moins une première couche isolante interne parmi la pluralité de premières couches isolantes, et éventuellement l'une des deux premières couches isolantes les plus externes soit entrant en contact avec la couche de semi-conducteur à oxyde soit entrant en contact avec l'électrode de grille.

4. Dispositif semi-conducteur selon l'une quelconque des revendications précédentes, une première couche isolante parmi la pluralité de premières couches isolantes étant disposée entre la deuxième couche isolante et la troisième couche isolante.

5. Dispositif semi-conducteur selon l'une quelconque des revendications précédentes, l'épaisseur de chaque première couche isolante de la pluralité de premières couches isolantes dans le sens de l'épaisseur de la couche isolante de grille étant supérieure à l'épaisseur de chaque couche parmi la deuxième couche isolante et la troisième couche isolante dans le sens de l'épaisseur de la couche isolante de grille.

6. Dispositif semi-conducteur selon l'une quelconque des revendications précédentes, l'épaisseur d'au moins une couche parmi la deuxième couche isolante ou la troisième couche isolante dans le sens de l'épaisseur de la couche isolante de grille étant inférieure ou égale à 3Å.

7. Dispositif semi-conducteur selon l'une quelconque des revendications précédentes, l'épaisseur de chaque première couche isolante de la pluralité de premières couches isolantes dans le sens de l'épaisseur de la couche isolante de grille étant supérieure ou égale à 5Å.

8. Dispositif semi-conducteur selon l'une quelconque des revendications précédentes, l'épaisseur de la couche isolante de grille dans le sens de l'épaisseur de la couche isolante de grille étant comprise entre 3 nm et 10 nm.

9. Dispositif semi-conducteur selon l'une quelconque des revendications précédentes, la somme des couches de la pluralité de premières couches isolantes, de la deuxième couche isolante et de la troisième couche isolante étant 4n+1, où n représente un nombre naturel.

10. Dispositif semi-conducteur selon l'une quelconque des revendications précédentes,
ladite deuxième couche isolante comprenant une pluralité de deuxièmes couches isolantes,
ladite troisième couche isolante comprenant une pluralité de troisièmes couches isolantes, et
ladite pluralité de deuxièmes couches isolantes et la pluralité de troisièmes couches isolantes étant disposées alternativement une par une dans le sens de l'épaisseur de la couche isolante de grille.

11. Dispositif semi-conducteur selon l'une quelconque des revendications précédentes, la différence de bande interdite d'énergie entre la deuxième couche isolante et la troisième couche isolante étant supérieure ou égale à 5 eV.

12. Dispositif semi-conducteur selon l'une quelconque des revendications précédentes, ladite troisième couche isolante comprenant un oxyde comprenant au moins un élément parmi le silicium (Si) ou le magnésium (Mg).

13. Dispositif semi-conducteur selon l'une quelconque des revendications précédentes, ladite deuxième couche isolante comprenant au moins un élément parmi le titane (Ti) ou le hafnium (Hf).

14. Dispositif semi-conducteur selon l'une quelconque des revendications précédentes, la différence de bande interdite d'énergie entre une première couche isolante parmi la pluralité de premières couches isolantes et au moins une couche parmi la deuxième couche isolante ou la troisième couche isolante étant supérieure ou égale à 2 eV.

15. Dispositif à semi-conducteur selon l'une quelconque des revendications précédentes, ladite pluralité de premières couches isolantes comprenant chacune indépendamment un oxyde, ledit oxyde comprenant au moins un élément parmi l'aluminium (Al), le calcium (Ca), l'yttrium (Y), le zirconium (Zr) ou le hafnium (Hf).
